# EUROPÄISCHE PATENTANMELDUNG

(11) **EP 1 213 752 A2**
(43) Veröffentlichungstag der Anmeldung: **12.06.2002**
(21) Anmeldenummer: 01127070.9
(22) Anmeldetag: 14.11.2001
(51) Int. Cl.: H01L 21/66

(54) **Verfahren zum automatischen Überwachen der Herstellung von integrierten Schaltkreisen abhängig von der Anzahl ausgeführter Bearbeitungszyklen, zugehörige Einheiten und zugehöriges Programm**

(30) Priorität: 06.12.2000 DE 10060631
(71) Anmelder: Infineon Technologies AG, 81669 München (DE)
(72) Erfinder: Steinkirchner, Erwin, 94315 Straubing (DE); Maeritz, Jörn, 93152 Zeiler/Nittendorf (DE)
(74) Vertreter: Kindermann, Peter, Dipl.-Ing.

(57) **Zusammenfassung**

Erläutert wird unter anderem ein Verfahren, bei dem die Anzahl der Halbzeuge pro Fertigungseinheit (N) vorgegeben wird (Schritt 12). Die Istanzahl (zIst) der beim Bearbeiten der Fertigungseinheit ausgeführten Bearbeitungszyklen wird automatisch ermittelt (Schritt 14). Anschließend wird abhängig von der Anzahl der Halbzeuge pro Fertigungseinheit (N) und abhängig von der Istanzahl (zIst) eine Prüfung auf Fertigungsfehler ausgeführt. Das Verfahren ermöglicht eine schnelle und frühzeitige Erfassung von Bedienfehlern.

## Beschreibung

Die Erfindung betrifft ein Verfahren, bei dem die Anzahl von Halbzeugen pro Fertigungseinheit oder die Sollanzahl von Bearbeitungszyklen bei einer unterbrechungsfreien Ausführung der Bearbeitungszyklen vorgegeben wird. Während der Bearbeitungszyklen werden mehrere Bearbeitungsschritte zur Fertigung mehrerer integrierter Schaltkreise aus dem Halbzeug ausgeführt. In der Regel sind die Bearbeitungsschritte gleich, weil gleich aufgebaute Schaltkreise aus einem Halbzeug hergestellt werden.

Eine Fertigungseinheit wird durch die Logistik des Fertigungssystems festgelegt. So gibt es beispielsweise Transporteinheiten und Beschickungseinheiten. Die Transporteinheit enthält eine Anzahl von Halbzeugen, die einerseits möglichst groß ist, um den logistischen Aufwand gering zu halten, beispielsweise die Anzahl der zu vergebenden Namen, und die andererseits jedoch nicht so groß ist, dass sich die Fertigungseinheit nur unter erschwerten Bedingungen transportierten lässt. Bei 6-Zoll-Siliziumscheiben enthält beispielsweise ein Fertigungslos 50 Siliziumscheiben. Das Fertigungslos hat ein Gewicht von etwa 2 bis 3 kg, so dass es noch vergleichsweise einfach zu transportieren ist. Eine Transporteinheit enthält beispielsweise mehrere Beschickungseinheiten, die jeweils eine vorgegebene Anzahl von Halbzeugen enthalten, die gemeinsam in eine Bearbeitungsanlage durch eine Bedienperson zu bringen sind. Beispielsweise werden sogenannte Fertigungshorden eingesetzt, die 25 Siliziumscheiben enthalten. Die genannten Zahlen betreffen 6-Zoll-Siliziumscheiben. Bei Siliziumscheiben mit einem anderen Durchmesser ändert sich die Anzahl der Halbzeuge pro Fertigungseinheit.

Ein Bearbeitungszyklus wird durch die Zeit festgelegt, in der die eingesetzte Fertigungsanlage ohne Unterbrechung an einem Halbzeug arbeitet. Mit der Bearbeitung des nächsten Halbzeuges beginnt ein neuer Bearbeitungszyklus. Ein Bearbeitungszyklus ist auch beendet, wenn er vor dem Erreichen einer Sollanzahl für die Bearbeitungsschritte pro Zyklus abgebrochen wird. In diesem Fall muss für dasselbe Halbzeug ein weiterer Bearbeitungszyklus gestartet werden, um die noch verbliebenen Bearbeitungsschritte auszuführen.

Bei der Herstellung eines integrierten Schaltkreises durchläuft ein Halbzeug eine Vielzahl von Prozessstufen, z.B. etwa 200. Als Halbzeug werden beispielsweise Siliziumscheiben eingesetzt, die während der Herstellung der integrierten Schaltkreise mehrfach beschichtet, mit Fotolack überzogen, belichtet, entwickelt, geätzt und geprüft werden müssen. Insbesondere beim Belichten und beim Prüfen werden eine Vielzahl von gleichartigen Bearbeitungsschritten pro Siliziumscheibe und pro Bearbeitungszyklus ausgeführt.

So wird beim Belichten jeweils nur ein Teilbereich der Siliziumscheibe belichtet, der für eine oder mehrere integrierte Schaltkreise vorgesehen ist. Zur Ausführung von Belichtungen werden Belichtungsanlagen, z.B. sogenannte Stepper, sogenannte Step- und Scansysteme sowie sogenannte Scanner eingesetzt.

Aus unterschiedlichen Gründen, z.B. Stromausfall oder ein Anlagenfehler, kann es an der die Bearbeitung ausführenden Anlage zu Fertigungsunterbrechungen kommen. In solchen Fällen muss eine Bedienperson die Anlage wieder in Betrieb nehmen und dabei die Bearbeitung möglichst an der Stelle fortsetzen, an der die Unterbrechung auftrat. Bei der Wiederinbetriebnahme kommt es unter Umständen zu Bedienfehlern und damit zu Fertigungsfehlern. Werden die Bedienfehler nicht oder zu spät erkannt, so sinkt die Ausbeute.

Die Bedienperson muss meist mehrere Anlagen bedienen, so dass auch bei sehr konzentrierter Arbeit Fertigungsfehler durch Fehlbedienungen nicht vermeidbar sind. Bisher lassen sich solche Fehler durch eine vollständige Kontrolle aller bearbeiteten Halbzeuge erfassen, z.B. mit Hilfe von Verfahren der Bildbearbeitung.

Es ist Aufgabe der Erfindung, zum automatischen Überwachen der Herstellung von integrierten Schaltkreisen ein einfaches Verfahren anzugeben, mit dessen Hilfe insbesondere eine hohe Ausbeute erzielt wird und mit dessen Hilfe insbesondere Bedienfehler schnell erfasst werden können. Außerdem sollen ein zugehöriges Programm, eine zugehörige Datenverarbeitungsanlage und eine zugehörige Bearbeitungsanlage zur Herstellung von integrierten Schaltkreisen angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Die Erfindung geht von der Überlegung aus, dass typische Bedienfehler zu einer Anzahl von Bearbeitungszyklen pro Fertigungseinheit führen, die von der Sollanzahl der Bearbeitungszyklen je Fertigungseinheit abweicht. Es werden entweder zu viele Bearbeitungszyklen ausgeführt, d.h. ein Halbzeug oder mehrere Halbzeuge werden doppelt bearbeitet, oder es werden zu wenige Bearbeitungszyklen ausgeführt, d.h. ein Teil der Halbzeuge wird nicht bearbeitet. Beispielsweise kommt es bei der Wiederinbetriebnahme einer Belichtungsanlage durch das Verwechseln der Horden eines gerade bearbeiteten Loses dazu, dass nach der Unterbrechung an Stelle der zweiten Horde erneut die erste Horde weiterbearbeitet wird. Halbzeuge der ersten Horde werden also mehrfach bearbeitet. Erst nach dem Bearbeiten der Halbzeuge der ersten Horde wird dann die zweite Horde bearbeitet. Es treten auch Fertigungsfehler dadurch auf, dass nach einer Unterbrechung wieder mit dem ersten Halbzeug einer Horde begonnen wird, obwohl bereits einige Halbzeuge derselben Horde bearbeitet worden sind. Durch ein systematisches Aufbereiten der Prozess- und Anlagendaten ist es möglich, einen Bedienfehler sofort zu erkennen und unverzüglich Maßnahmen zur Behebung des Bedienfehlers einzuleiten.

Beim erfindungsgemäßen Verfahren wird zusätzlich zu den eingangs genannten Verfahrensschritten die Istanzahl der beim Bearbeiten der Fertigungseinheit ausgeführten Bearbeitungszyklen automatisch ermittelt. Abhängig von der Anzahl der Halbzeuge pro Fertigungseinheit oder der Sollanzahl der Bearbeitungszyklen und abhängig von der Istanzahl wird automatisch eine Prüfung auf Fertigungsfehler durchgeführt.

Zum automatischen Erfassen der Istanzahl der beim Bearbeiten der Fertigungseinheit ausgeführten Bearbeitungszyklen wird beispielsweise der Zählerstand eines Zykluszählers der zur Bearbeitung ausführenden Anlage ausgelesen. Durch das automatische Auslesen des Zählerstandes und durch das automatische Prüfen wird die Bedienperson nicht mit zusätzlichen Arbeitsgängen belastet.

Durch die beim erfindungsgemäßen Verfahren verwendeten auf die Anzahl der Bearbeitungszyklen bezogenen Eingangsgrößen für die Prüfung lässt sich das Verfahren unter Durchführung einfacher Rechenoperationen ausführen. So muss bei einer unterbrechungsfreien Ausführung der Bearbeitungszyklen die Anzahl der Halbzeuge pro Fertigungseinheit bzw. die Sollanzahl der Bearbeitungszyklen mit der Istanzahl der beim Bearbeiten der Fertigungseinheit ausgeführten Bearbeitungszyklen übereinstimmen. Abweichungen sind möglicherweise auf Bedienfehler zurückzuführen. Bei einem Fehler wird eine Fehlernachricht für die Bedienperson erzeugt. Alternativ oder kumulativ lasst sich auch die Fertigung automatisch beeinflussen.

Die Anzahl der Halbzeuge pro Fertigungseinheit bzw. die Sollanzahl der Bearbeitungszyklen lässt sich beispielsweise manuell vorgeben. Außerdem ist die Sollanzahl in einem ME-System (Manufacturing Execution System) verfügbar.

Durch das erfindungsgemäße Verfahren werden Bedienfehler auf einfache Weise erfasst. Aufgrund des Erfassens der Bedienfehler können bestimmte Halbzeuge gezielt kontrolliert werden. Abhängig von den erfassten Bedienfehlern wird die Produktion gelenkt. Dadurch lässt sich die Ausbeute an funktionsfähigen integrierten Schaltkreisen je Fertigungseinheit erhöhen. Außerdem tritt ein Kapazitätsgewinn ein, da die Bearbeitung von fehlerhaften Halbzeugen unterbleibt.

Bei einer Weiterbildung des erfindungsgemäßen Verfahrens wird automatisch die Anzahl von unterbrochenen Bearbeitungszyklen ermittelt. Die Prüfung auf Fertigungsfehler wird auch abhängig von der Anzahl unterbrochener Bearbeitungszyklen ausgeführt. Bei einer Ausgestaltung wird die Differenz aus der Istanzahl der beim Bearbeiten der Fertigungseinheit ausgeführten Bearbeitungszyklen und der Anzahl der unterbrochenen Bearbeitungszyklen berechnet. Für jeden unterbrochenen Bearbeitungszyklus muss nämlich ein weiterer Bearbeitungszyklus ausgeführt werden, in dem dieselbe Siliziumscheibe zu Ende bearbeitet wird. Bei der Unterbrechung innerhalb eines Bearbeitungszyklus und damit beim Ausführen eines unvollständigen Bearbeitungszyklus kommt es bei der Wiederinbetriebnahme immer wieder zu Bedienfehlern. Beispielsweise wird die Bearbeitung mit der Bearbeitung eines unbearbeiteten Halbzeuges fortgesetzt, ohne die Bearbeitung des nur teilweise bearbeiteten Halbzeuges fortzusetzen. Die Anzahl der erfassbaren Bedienfehler erhöht sich durch die Weiterbildung beträchtlich.

Zusätzlich oder kumulativ zum Erfassen der Anzahl von unterbrochenen Bearbeitungszyklen wird bei einer nächsten Weiterbildung des erfindungsgemäßen Verfahrens die Anzahl von nachzuarbeitenden oder nachbearbeiteten Halbzeugen der Fertigungseinheit automatisch oder manuell ermittelt. Die Prüfung auf Bedienfehler wird abhängig von der Anzahl der nachgearbeiteten Halbzeuge ausgeführt. Bei einer Ausgestaltung wird die Differenz aus der Istanzahl und der Anzahl der bereits nachgearbeiteten Halbzeuge berechnet. Durch die Weiterbildung ist es möglich, der Fertigungseinheit unkompliziert ein Halbzeug oder mehrere Halbzeuge hinzuzufügen, die aus einer bereits bearbeiteten Fertigungseinheit stammen. Die betreffenden Halbzeuge sind nachzubearbeiten, weil bei ihrer Fertigung unvorhergesehene Fehler aufgetreten sind. Die Zuordnung der nachzubearbeitenden Halbzeuge zu der Fertigungseinheit lässt sich damit nicht von vornherein mit einem zentralen Logistiksystem erfassen. Durch die Weiterbildung ist es möglich, nachzubearbeitende Halbzeuge ohne großen logistischen Aufwand zu berücksichtigen. Das Umbenennen von Fertigungseinheiten im zentralen Logistiksystem ist vermeidbar, weil die nachbearbeiteten Halbzeuge je Fertigungseinheit separat erfasst werden.

Bei einer nächsten Weiterbildung des erfindungsgemäßen Verfahrens wird ein Fertigungsfehler erfasst, wenn:
- Die Anzahl der Halbzeuge oder die Sollanzahl der Bearbeitungszyklen von der Istanzahl abweicht.
- Die Anzahl der Halbzeuge oder die Sollanzahl der Bearbeitungszyklen von der um die Anzahl der unterbrochenen Bearbeitungszyklen verminderten Istanzahl abweicht.
- Wenn die Anzahl der Halbzeuge oder die Sollanzahl der Bearbeitungszyklen von der um die Anzahl der bereits nachgearbeiteten Halbzeuge verminderten Istanzahl abweicht.
- Wenn die Anzahl der Halbzeuge oder die Sollanzahl der Bearbeitungszyklen von der um die Anzahl der unterbrochenen Bearbeitungszyklen und um die Anzahl der bereits nachgearbeiteten Halbzeuge verminderte Istanzahl abweicht.

Insbesondere bei der zuletzt erwähnten Berechnungsvorschrift wird der Großteil der Bedienfehler erfasst.

Die automatische Prüfung wird bei einer nächsten Weiterbildung nach dem Bearbeiten einer Fertigungseinheit in der betrachteten Bearbeitungsstufe und vor dem Ausführen der folgenden Bearbeitungsstufe für die Halbzeuge der Fertigungseinheit ausgeführt. Die weitere Fertigung des Halbzeuges wird abhängig vom Prüfergebnis gelenkt. Beim Auftreten eines Fehlers werden bei einer Ausgestaltung Maßnahmen zur Wiederholung eines Bearbeitungszyklus für das fehlerhafte Halbzeug oder zur Wiederholung der Bearbeitung der Fertigungseinheit ausgeführt. Durch die führzeitige Erfassung des Fehlers können die Folgen eines Bedienfehlers in vielen Fällen noch mit vergleichsweise geringem Aufwand beseitigt werden. Ist eine Beseitigung nicht mehr möglich, so werden die aufgrund des Bedienfehlers fehlerhaften Halbzeuge zumindest nicht weiter bearbeitet. Diese Bearbeitung wäre unnötig, da die fehlerhaften Halbzeuge ohnehin nicht mehr verwendet werden können. Durch das Vermeiden der Bearbeitung von fehlerhaften Halbzeugen lassen sich die nicht belegten Fertigungskapazitäten für andere Zwecke nutzen.

Bei einer nächsten Weiterbildung wird während der Bearbeitung in einem Bearbeitungszyklus eine Siliziumscheibe in aufeinanderfolgenden Belichtungsschritten abschnittsweise belichtet. Dabei wird die gleiche Belichtungsmaske für die Belichtungsschritte eingesetzt. Die Maske enthält Strukturen für einen oder für mehrere integrierte Schaltkreise. Insbesondere der Belichtungsprozess gestattet es, eine Nachbearbeitung einer fehlerhaft belichteten Siliziumscheibe auszuführen, wenn der Fehler unmittelbar nach der Belichtung und noch vor dem anschließenden Ätzen erfasst wird. Wird der Fehler frühzeitig erkannt, beispielsweise vor dem Ätzen, so wird die Fotolackschicht vom Halbzeug wieder entfernt. Anschließend wird neuer Fotolack aufgebracht und die Belichtung wiederholt.

Aber auch bei Prüfschritten lässt sich das erfindungsgemäße Verfahren mit großem Nutzen einsetzen. Während eines Bearbeitungszyklus werden auf einer Siliziumscheibe aufgebrachte Schaltkreisen in aufeinanderfolgenden Prüfschritten geprüft. Die Prüfschritte sind beispielsweise Wiederholungen des gleichen Verfahrens zum Prüfen eines oder mehrerer Schaltkreise. Wird das Auslassen von Prüfschritten vor dem Vereinzeln der Schaltkreise erfasst, so kann der Prüfzyklus erneut ausgeführt werden, um sicherzustellen, dass nur fehlerfreie Schaltkreise hergestellt werden. Nach dem Vereinzeln und dem Vermischen mit anderen Schaltkreisen ist es nämlich nicht mehr möglich, die nicht geprüften Schaltkreise zu ermitteln. Die Prüfung der einzelnen Schaltkreise ist nach dem Vereinzeln erheblich schwieriger als das Prüfen des Halbzeuges. So müssen die Schaltkreise aufwendiger für das Prüfen positioniert werden.

Das erfindungsgemäße Verfahren lässt sich separat für jeweils eine die Bearbeitungsschritte ausführende Anlage durchführen. Ein die Anlagen verknüpfendes Datennetz wird in diesem Fall nicht benötigt.

Alternativ werden mindestens zwei Überwachungsverfahren für zwei gleichartig oder voneinander verschieden aufgebaute Anlagen auf einer Datenverarbeitungsanlage ausgeführt, die mit den Anlagen vorzugsweise über ein lokales Datenübertragungsnetz verbunden ist. Durch diese Maßnahme lässt sich die Datenverarbeitungsanlage sehr effektiv nutzen. Als Datenübertragungsnetz wird beispielsweise ein Ethernet eingesetzt, d.h. ein Netz, mit dessen Hilfe mehrere hundert Meter überbrückbar sind. Beim Nutzen eines Datenübertragungsnetzes lasst sich an eine Bedienperson leicht eine Fehlermeldung über das Datenübertragungsnetz übertragen, z.B. als sogenanntes eMail.

Die Erfindung betrifft außerdem ein Programm mit einer Befehlsfolge, bei deren Ausführung durch einen Prozessor das erfindungsgemäße Verfahren oder eine seiner Weiterbildungen ausgeführt wird. Weiterhin betrifft die Erfindung eine Datenverarbeitungsanlage mit einem solchen Programm, d.h. beim Betrieb der Datenverarbeitungsanlage wird das erfindungsgemäße Verfahren oder eine seiner Weiterbildungen ausgeführt. Damit gelten die oben genannten technischen Wirkungen auch für das Programm und die Datenverarbeitungsanlage. Das Programm und die Datenverarbeitungsanlage sind Bestandteile eines sogenannten APC-Systems (Advanced Process Control System).

Außerdem betrifft die Erfindung eine Bearbeitungsanlage zur Herstellung von integrierten Schaltkreisen. Die Bearbeitungsanlage ist so aufgebaut, dass sie zur Ausführung des erfindungsgemäßen Verfahrens oder einer seiner Weiterbildungen geeignet ist. Insbesondere erfasst die Bearbeitungsanlage automatisch die für die Prüfung benötigte Istanzahl der Bearbeitungsschritte bzw. die Istzyklenanzahl. Auch für die Bearbeitungsanlage gelten die oben genannten technischen Wirkungen.

Im Folgenden werden Ausführungsbeispiele der Erfindung an Hand der beiliegenden Zeichnungen erläutert. Darin zeigen:
- Figur 1: Verfahrensschritte zur Überwachung der Belichtung von Siliziumscheiben, und
- Figur 2: eine Darstellung von während der Belichtung erfassten Daten und aus diesen Daten zur Überwachung ermittelten Daten.

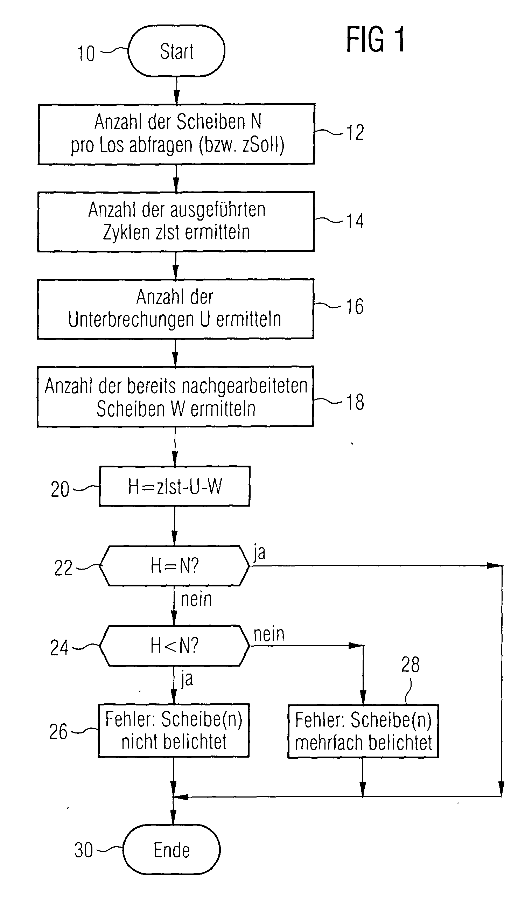

Figur 1 zeigt Verfahrensschritte zum Überwachen der Belichtung von Siliziumscheiben abhangig von der Anzahl ausgeführter Bearbeitungszyklen. Es wird jeweils die Belichtung eines Loses überwacht, das aus zwei Horden besteht, die ihrerseits jeweils eine vorgegebene Anzahl von Siliziumscheiben enthalten. Die Belichtung der Siliziumscheiben wird unter Einsatz üblicher Belichtungsverfahren ausgeführt.

Zur Steuerung der Belichtungsanlage wird ein sogenanntes APC-System (Advanced Process Control System) genutzt, das einen zentralen Rechner enthält, der mehrere Belichtungsanlagen überwacht. Außerdem überwacht der Rechner der Belichtung vorangehende und der Belichtung folgende Fertigungsstufen auf anderen Bearbeitungsanlagen. Der zentrale Rechner ist mit den Anlagen über ein lokales Datenübertragungsnetz verbunden. Außerdem hat der zentrale Rechner Zugriff auf die Daten eines sogenannten ME-Systems (Manufacturing Execution System), mit dessen Hilfe die Herstellung der integrierten Schaltkreise logistisch begleitet wird. Die in Figur 1 dargestellten Verfahrensschritte werden auf dem zentralen Rechner des APC-Systems ausgeführt.

Bei der Erläuterung des Verfahrens werden die folgenden Abkürzungen verwendet:
N: die Anzahl der Siliziumscheiben (Wafer), die eine Fertigungseinheit bilden, z.B. ein sogenanntes Los mit 50 Siliziumscheiben vom Durchmesser 6 Zoll. Gegebenenfalls wurden schon Siliziumscheiben aussortiert, so dass ein Los auch weniger als 50 Siliziumscheiben enthalten kann. Ein Los enthält beispielsweise zwei Horden, in denen ein gemeinsamer Rahmen jeweils 25 Siliziumscheiben aufnehmen kann.
zSoll: die Anzahl der auszuführenden Bearbeitungszyklen für die betrachtete Fertigungseinheit, falls keine Unterbrechungen der Bearbeitungszyklen auftreten. Die Größe zSoll stimmt mit der Größe N wertmäßig überein.
zIst: die Anzahl der ausgeführten Bearbeitungszyklen für die betrachtete Fertigungseinheit, gegebenenfalls sind auch vorzeitig abgebrochene Bearbeitungszyklen enthalten.
U: die Anzahl von vorzeitig abgebrochenen Bearbeitungszyklen beim Bearbeiten der betrachteten Fertigungseinheit.
W: die Anzahl der nachzuarbeitenden Siliziumscheiben in der betrachteten Fertigungseinheit. Die nachzuarbeitenden Siliziumscheiben W sind in der Anzahl N der Siliziumscheiben nicht enthalten.
H: eine Hilfsgröße zum Überwachen der Anzahl ausgeführter Bearbeitungszyklen während der Bearbeitung einer Fertigungseinheit.

Das Verfahren beginnt in einem Verfahrensschritt 10 nachdem eine Fertigungseinheit belichtet worden ist. Die während der Belichtung erfassten Daten wurden in einer Speichereinheit des zentralen Rechners gespeichert.

In einem dem Verfahrensschritt 10 folgenden Verfahrensschritt wird die Anzahl der Siliziumscheiben N pro Los abgefragt, beispielsweise beim ME-System. Alternativ wird die Sollanzahl der Bearbeitungszyklen zSoll an Stelle der Anzahl der Siliziumscheiben N verwendet.

In einem nächsten Verfahrensschritt 14 wird die Anzahl der ausgeführten Zyklen zIst ermittelt. Dazu werden beispielsweise die Daten gezählt, die von der Belichtungsanlage je Belichtungszyklus ausgegeben worden sind. Beispielsweise wird für jeden Belichtungszyklus ein Datensatz ausgegeben, der die Anzahl der Bearbeitungsschritte, die Prozesszeit und das Prozessdatum enthält. Durch Zählen der Anzahl der Datensätze lässt sich die Anzahl der Belichtungszyklen ermitteln.

In einem Verfahrensschritt 16 wird die Anzahl der Unterbrechungen U von Bearbeitungszyklen ermittelt, indem beispielsweise eine Sollanzahl von Bearbeitungsschritten je Bearbeitungszyklus mit einer erfassten Istanzahl von Bearbeitungsschritten verglichen wird. Treten in aufeinanderfolgenden Bearbeitungszyklen Unterbrechungen auf, so wird nur eine Unterbrechung gezählt, weil davon ausgegangen wird, dass die unterbrochene Bearbeitung fortgesetzt wurde. Weicht die Anzahl der Bearbeitungsschritte in einem Bearbeitungszyklus von einer vorgegebenen Sollanzahl ab, so muss eine Unterbrechung vorliegen. Ein Zähler für die Unterbrechung U wird erhöht. Anschließend werden die Daten des nächsten Datensatzes nach demselben Vergleichskriterium geprüft.

In einem Verfahrensschritt 18 wird die Anzahl der bereits nachgearbeiteten Siliziumscheiben W ermittelt. Beispielsweise gibt die Bedienperson die Anzahl dieser Siliziumscheiben über eine Tastatur an der Belichtungsanlage ein. Die Belichtungsanlage sendet dem zentralen Rechner ein Datum, dessen Wert mit der eingegebenen Anzahl übereinstimmt.

In einem Verfahrensschritt 20 wird eine Hilfsgröße H berechnet, indem von der Anzahl der tatsächlich ausgeführten Bearbeitungszyklen zIst die Anzahl der Unterbrechungen U und die Anzahl der bereits nachgearbeiteten Siliziumscheiben W subtrahiert wird. Bei der Berechnung werden die in den Verfahrensschritten 14, 16 und 18 ermittelten Größen genutzt.

In einem Verfahrensschritt 22 wird geprüft, ob die Hilfsgröße H einen Wert hat, der mit der Anzahl der Siliziumscheiben N übereinstimmt. Liegt keine Übereinstimmung vor, so folgt nach dem Verfahrensschritt 22 ein Verfahrensschritt 24, in welchem geprüft wird, ob die Hilfsgröße H einen Wert hat, der kleiner als die Anzahl der Siliziumscheiben N ist. Ist der Wert der Hilfsgröße H kleiner, so folgt nach dem Verfahrensschritt 24 ein Verfahrensschritt 26, in welchem eine Fehlermeldung für die Bedienperson erzeugt wird. Die Fehlermeldung weist darauf hin, dass eine Siliziumscheibe oder mehrere Siliziumscheiben in der geprüften Fertigungseinheit nicht ordnungsgemäß belichtet worden sind.

Wird im Verfahrensschritt 24 dagegen festgestellt, dass die Hilfsgröße H nicht kleiner als die Anzahl N ist, das bedeutet, die Hilfsgröße H ist größer, so folgt unmittelbar nach dem Verfahrensschritt 24 ein Verfahrensschritt 28. Im Verfahrensschritt 28 wird eine Fehlermeldung an die Bedienperson gesendet. Die Fehlermeldung weist darauf hin, dass eine Siliziumscheibe oder mehrere Siliziumscheiben der aktuell geprüften Fertigungseinheit mehrfach belichtet worden sind.

Abhängig von den Fehlermeldungen entnimmt die Bedienperson eine Siliziumscheibe der Fertigungseinheit oder die gesamte Fertigungseinheit aus dem normalen Fertigungsprozess und veranlasst die Nachbearbeitung.

Nach dem Verfahrensschritt 26 bzw. 28 wird das Verfahren in einem Verfahrensschritt 30 beendet. Der Verfahrensschritt 30 folgt auch unmittelbar nach dem Verfahrensschritt 22, wenn dort festgestellt wird, dass die Hilfsgröße H einen Wert hat, der mit der Anzahl der Siliziumscheiben N übereinstimmt.

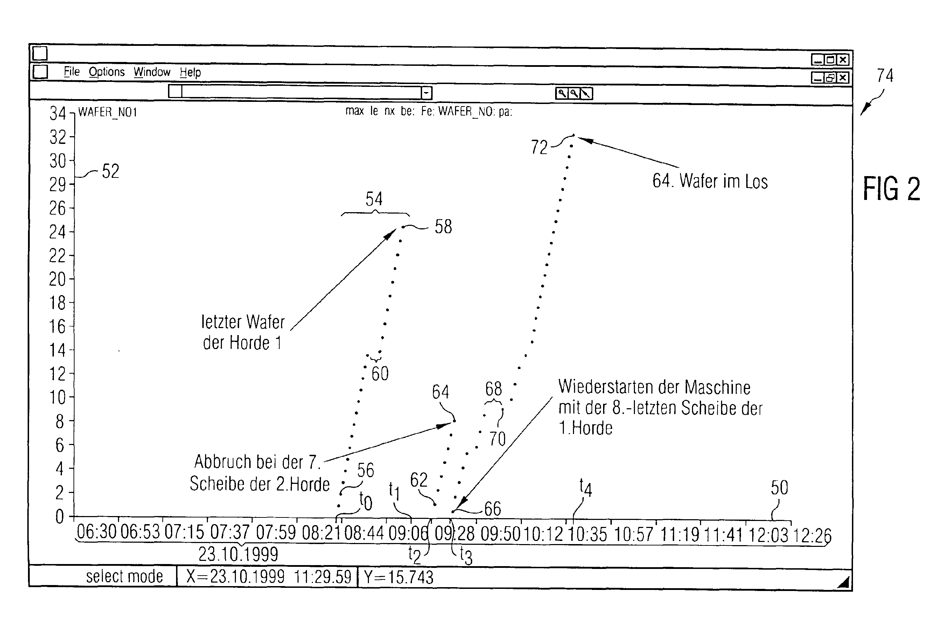

Figur 2 zeigt die Darstellung von Daten, die während der Belichtung eines Loses erfasst worden sind, das 49 Siliziumscheiben in zwei Horden mit 24 bzw. 25 Siliziumscheiben enthielt. Auf einer Abszissenachse 50 ist das Fertigungsdatum und die Fertigungszeit abgetragen. Eine Ordinatenachse 52 zeigt durch die Belichtungsanlage automatisch festgelegte Nummern der bearbeiteten Siliziumscheiben. Ein Teil 54 der Darstellung betrifft die erste Horde des Loses. Die erste Horde enthält 24 Siliziumscheiben, bei deren Belichtung keine Unterbrechungen aufgetreten sind. Die Belichtung der Siliziumscheiben der ersten Horde begann zu einem Zeitpunkt t0 am 23.10.1999 um etwa 8.40 Uhr. Für jede Siliziumscheibe der ersten Horde ist der Belichtungszyklus jeweils durch einen Punkt dargestellt, siehe beispielsweise Punkt 56 für die dritte Siliziumscheibe der ersten Horde. Die Bearbeitung der 24. Siliziumscheibe der ersten Horde ist durch einen Punkt 58 dargestellt. Die Bearbeitung der ersten Horde wurde zu einem Zeitpunkt t1 etwa gegen 9.16 Uhr beendet. Während der Bearbeitung der Siliziumscheiben der ersten Horde trat nur eine kurze Unterbrechung zwischen zwei vollständig ausgeführten Belichtungszyklen auf, siehe Klammer 60, so dass keine Unterbrechung U erfasst wird. Zu einem Zeitpunkt t2, der nach dem Zeitpunkt t1 liegt, wurde in der Belichtungsanlage ein zweiter Teilauftrag begonnen. Es ist zu vermuten, dass die Bedienperson richtig die erste Horde von der Belichtungsanlage genommen und die Belichtungsanlage daraufhin mit der zweiten Horde beschickt hat. Zum Zeitpunkt t2 wurde die Belichtung der ersten Siliziumscheibe der zweiten Horde beendet, siehe Punkt 62. Nach dem Belichten der siebten Siliziumscheibe der zweiten Horde, siehe Punkt 64, kam es zu einer Unterbrechung. Die Bedienperson beseitigte die Ursache der Unterbrechung und setzte die Belichtung zu einem Zeitpunkt t3 fort, siehe Punkt 66.

Aufgrund der in Figur 2 dargestellten Daten lässt sich vermuten, dass beim Fortsetzen der Belichtung ein Bedienfehler aufgetreten ist. Die Bedienperson hat wohl irrtümlich die Belichtungsanlage nach der Unterbrechung wieder mit der ersten Horde beschickt und dann die Bearbeitung mit der achtletzten Siliziumscheibe der ersten Horde an Stelle der achten Siliziumscheibe der zweiten Horde fortgesetzt, siehe Punkt 66. Es wurden anschließend acht Belichtungszyklen durchgeführt. Eine Klammer 68 zeigt eine Unterbrechung, die vermutlich auf den Wechsel der Horden in der Belichtungsanlage zurückzuführen ist. Nach dem Wechsel der Horden wurde mit der Belichtung der ersten Siliziumscheibe der zweiten Horde begonnen, siehe Punkt 70. Anschließend sind die 25 Siliziumscheiben der zweiten Horde belichtet worden. Ein Punkt 72 zeigt den Belichtungszyklus für die fünfundzwanzigste Siliziumscheibe der zweiten Horde. Die Bearbeitung des Loses wurde zu einem Zeitpunkt t4 beendet.

Bei der Durchführung des oben an Hand der Figur 1 erläuterten Verfahrens wird im Verfahrensschritt 12 festgestellt, dass N = 49 Siliziumscheiben im Los enthalten waren. Im Verfahrensschritt 14 wird ermittelt, dass zIst = 64 Belichtungszyklen ausgeführt worden sind. Im Verfahrensschritt 16 wird ermittelt, dass keine Unterbrechungen U = 0 während der Bearbeitung des Loses aufgetreten sind. Die Anzahl der bereits nachgearbeiteten Siliziumscheiben W wird im Verfahrensschritt 18 zu W = 0 ermittelt. Die Hilfsgröße im Verfahrensschritt H hat den Wert 64 und unterscheidet sich damit beträchtlich von der Anzahl N = 49. Deshalb wird im Verfahrensschritt 28 die Bedienperson darauf hingewiesen, dass Siliziumscheiben des geprüften Loses mehrfach belichtet worden sind. Zur Benachrichtigung der Bedienperson wird beispielsweise eine eMail über das Datenubertragungsnetz vom zentralen Rechner zur Belichtungsanlage gesendet. Die in Figur 2 gezeigte Darstellung wird der Bedienperson auf einem Bildschirm in einem Fenster 74 angezeigt.

## Patentansprüche

1. Verfahren zum automatischen Überwachen der Herstellung von integrierten Schaltkreisen,
bei dem die Anzahl (N) von Halbzeugen pro Fertigungseinheit oder eine Sollanzahl (zSoll) von Bearbeitungszyklen bei einer unterbrechungsfreien Ausführung der Bearbeitungszyklen vorgegeben wird (Schritt 12),
bei dem während der Bearbeitungszyklen mehrere Bearbeitungsschritte zur Fertigung mehrerer integrierter Schaltkreise aus dem Halbzeug ausgeführt werden,
bei dem die Istanzahl (zIst) der beim Bearbeiten der Halbzeuge der Fertigungseinheit ausgeführten Bearbeitungszyklen automatisch ermittelt wird (Schritt 14),
und bei dem abhängig von der Anzahl der Halbzeuge pro Fertigungseinheit (N) oder der Sollanzahl (zSoll) und abhängig von der Istanzahl (zIst) automatisch eine Prüfung auf Fertigungsfehler ausgeführt wird (Schritte 22, 24).

2. Verfahren nach Anspruch 1, **dadurch gekennzeichnet, dass** automatisch die Anzahl (U) von unterbrochenen Bearbeitungszyklen ermittelt wird (Schritt 16),
dass die Prüfung abhängig von der Anzahl unterbrochener Bearbeitungszyklen (U) ausgeführt wird (Schritt 20),
und dass vorzugsweise die Differenz aus der Istanzahl (zIst) und der Anzahl der unterbrochenen Bearbeitungszyklen (U) berechnet wird (Schritt 20).

3. Verfahren nach einem der vorhergehenden Ansprüche, **dadurch gekennzeichnet, dass** automatisch oder manuell die Anzahl von nachzuarbeitenden oder nachbearbeiteten Halbzeugen (W) der Fertigungseinheit ermittelt wird (Schritt 18),
dass die Prüfung abhängig von der Anzahl der nachzuarbeitenden oder nachgearbeiteten Halbzeuge (W) ausgeführt wird,
und dass vorzugsweise die Differenz aus der Istanzahl (zIst) und der Anzahl der nachzuarbeitenden oder nachgearbeiteten Halbzeuge (W) berechnet wird (Schritt 20).

4. Verfahren nach einem der vorhergehenden Ansprüche, **dadurch gekennzeichnet, dass** ein Fertigungsfehler erfasst wird, wenn die Anzahl der Halbzeuge (N) oder die Sollanzahl (zSoll) von der Istanzahl (zIst), von der um die Anzahl der unterbrochenen Bearbeitungszyklen (U) verminderten Istanzahl (zIst), von der um die Anzahl der nachgearbeiteten Halbzeuge (W) verminderten Istanzahl (zIst) oder von der um die Anzahl der unterbrochenen Bearbeitungszyklen (U) und um die Anzahl der bereits nachgearbeiteten Halbzeuge (W) verminderten Istanzahl (zIst) abweicht.

5. Verfahren nach einem der vorhergehenden Ansprüche, **dadurch gekennzeichnet, dass** die automatische Prüfung nach dem Bearbeiten der Halbzeuge einer Fertigungseinheit und vor dem Ausführen einer folgenden Bearbeitungsstufe an den Halbzeugen der Fertigungseinheit erfolgt,
und dass die weitere Fertigung mindestens eines Halbzeugs der Fertigungseinheit abhängig vom Prüfergebnis gelenkt wird,
wobei beim Auftreten eines Fehlers vorzugsweise Maßnahmen zur Wiederholung eines Bearbeitungszyklus für das fehlerhafte Halbzeug und/oder zur Wiederholung der Bearbeitungszyklen für alle Halbzeuge der Fertigungseinheit ausgeführt werden.

6. Verfahren nach einem der vorhergehenden Ansprüche, **dadurch gekennzeichnet, dass** die Fertigungseinheit eine Gruppe von mehreren Halbzeugen ist, die gemeinsam zu einer Fertigungsanlage transportiert und/oder einer Fertigungsanlage zugeführt werden.

7. Verfahren nach einem der vorhergehenden Ansprüche, **dadurch gekennzeichnet, dass** während der Bearbeitung in einem Bearbeitungszyklus eine Siliziumscheibe in aufeinanderfolgenden Belichtungsschritten flächenabschnittsweise belichtet oder auf einer Siliziumscheibe aufgebrachte Schaltkreise in aufeinanderfolgenden Prüfschritten geprüft werden.

8. Verfahren nach einem der vorhergehenden Ansprüche, **dadurch gekennzeichnet, dass** das Verfahren separat für eine die Bearbeitungsschritte ausführende Anlage durchgeführt wird,
oder dass mindestens zwei Überwachungsverfahren für zwei Anlagen auf einer Datenverarbeitungsanlage ausgeführt werden, die mit den Anlagen vorzugsweise über ein lokales Datenübertragungsnetz verbunden ist,
und dass vorzugsweise eine Nachricht an eine Bedienperson als Fehlermeldung über das Datenübertragungsnetz gesendet wird.

9. Verfahren nach einem der vorhergehenden Ansprüche, **dadurch gekennzeichnet, dass** beim Erfassen eines Fertigungsfehlers eine Fehlermeldung erzeugt und/oder automatisch eine Fehlerbeseitigung veranlasst wird.

10. Programm mit einer Befehlsfolge, bei deren Ausführung durch einen Prozessor ein Verfahren nach einem der vorhergehenden Anspruche ausgeführt wird.

11. Datenverarbeitungsanlage, **dadurch gekennzeichnet, dass** die Datenverarbeitungsanlage so aufgebaut ist, dass bei ihrem Betrieb ein Verfahren nach einem der Ansprüche 1 bis 9 ausgeführt wird.

12. Bearbeitungsanlage zur Herstellung von integrierten Schaltkreisen, **dadurch gekennzeichnet, dass** die Bearbeitungsanlage so aufgebaut ist, dass sie zur Ausführung des Verfahrens nach einem der Ansprüche 1 bis 9 geeignet ist.
